Europäisches Patentamt

(19) European Patent Office

Office européen des brevets

(11) Numéro de publication : **0 005 720 B1**

(12) **FASCICULE DE BREVET EUROPÉEN**

(45) Date de publication du fascicule du brevet :
22.06.83

(21) Numéro de dépôt : **79101220.6**

(22) Date de dépôt : **23.04.79**

(51) Int. Cl.³ : **H 01 L 29/78**, H 01 L 21/265

---

(54) **Procédé de fabrication de transistors à effet de champ et à porte isolée à canal efficace très court.**

---

(30) Priorité : **30.05.78 US 910254**

(43) Date de publication de la demande :
**12.12.79 Bulletin 79/25**

(45) Mention de la délivrance du brevet :
**22.06.83 Bulletin 83/25**

(84) Etats contractants désignés :
**DE FR GB**

(56) Documents cités :
**FR A 1 577 669**
**TECHNICAL DIGEST 1977, International Electron Devices Meeting, December 5-7, 1977, Washington D. C. (US) J. TIHANYI et al. : « DIMOS a novel IC technology with submicron effective channel MOSFET's », page 399**
**I.E.E.E. Int. Electron Devices Meeting 9-11 Dec. 1974, Washington D. C. H. Kamioka et al. pp. 279-281**

(73) Titulaire : **International Business Machines Corporation**
**Armonk, N.Y. 10504 (US)**

(72) Inventeur : **Bassous, Ernest**
**750 Kappock St.**
**Riverdale New York 10463 (US)**
Inventeur : **Ning, Tak Hung**
**1720 Maxwell Drive**
**Yorktown Heights, N.Y. 10598 (US)**
Inventeur : **Osburn, Carlton Morris**
**41 Morningside Drive**
**Croton-on-Hudson, N.Y. 10520 (US)**

(74) Mandataire : **Klein, Daniel**
**COMPAGNIE IBM FRANCE Département de Propriété Industrielle**
**F-06610 La Gaude (FR)**

EP 0 005 720 B1

Jouve, 18, rue St-Denis, 75001 Paris, France

Procédé de fabrication de transistors à effet de champ et à porte isolée à canal efficace très court.

Description

Domaine technique

La présente invention concerne un procédé de fabrication de transistors à effet de champ et à porte isolée possédant un canal efficace très court, et, plus particulièrement, un procédé de fabrication de tels transistors dans lequel on peut faire varier de façon indépendante, par décapage chimique et implantation ionique, la valeur des tensions de seuil des deux régions constituant le canal, ainsi que la longueur de ces régions.

Technique antérieure

On sait que la réponse en fréquence ou la vitesse d'un transistor à effet de champ à porte isolée du type MOS (transistor métal-oxyde-semiconducteur) et désigné « IGFET » dans la littérature anglo-saxonne, est essentiellement fonction de la longueur du canal et de la capacité parasite, et est d'autant meilleure que cette longueur et cette capacité sont plus faibles. En effet, toute diminution de la longueur du canal a pour effet de réduire la durée du temps de transit des porteurs qui circulent entre la source et le drain, et toute diminution de la capacité provoque une diminution de la durée de la charge de cette capacité. Toutefois, un canal court s'accompagne d'une capacité parasite importante parce que c'est la séparation entre la source et le drain qui détermine l'importance de la diffusion latérale au-dessous de la porte pour une longueur donnée du canal, et parce que la région diffusée latérale, qui est elle aussi fortement dopée, représente une capacité importante entre la porte et la source ou entre la porte et le drain. Bien que ces capacités parasites puissent être réduites au moyen de diverses techniques faisant appel notamment à l'implantation ionique et à la formation d'une porte en polysilicium, ces techniques ne permettent pas de réduire la longueur du canal ni de commander la tension de seuil au-delà d'une certaine limite. D'autre part, les transistors MOS à canal court réalisés de façon classique présentent de faibles tensions de claquage.

Ce problème a partiellement été résolu dans l'art antérieur au moyen du transistor MOS à double diffusion, ou D/MOS, décrit dans un article de T. Cange, J. Koisic, H.J. Sigg et G.B. Dendelin intitulé « Double-Diffused MOS Transistor Achieves Microwave Gain », paru dans la publication « Electronics », en date du 15 février 1971, dont la réalisation nécessite une double diffusion effectuée au niveau de la future région de source et une unique diffusion effectuée au niveau de la future région de drain dans un substrat pratiquement intrinsèque ou très légèrement dopé. De façon plus détaillée, on fait d'abord croître un oxyde sur un substrat d'un matériau de départ qui peut être du type n-, p- ou

$\pi$, puis l'on pratique dans cet oxyde une première ouverture dans laquelle on procède à une diffusion de type p- pour constituer la région de source. On pratique ensuite une seconde ouverture correspondant à la future région de drain, et l'on effectue dans ces deux régions une diffusion de type n + dans l'atmosphère oxydante qui est employée de façon classique pour la réalisation de transistors MOS. On obtient ainsi un canal étroit de type p- à proximité immédiate de la source et une région de dérive (« drift ») prolongée dans le substrat jusqu'au drain, la longueur du canal étant égale ou inférieure à 1 micron. On termine le traitement au moyen des procédures standard prévues en matière de technologie MOS.

Bien qu'il permette d'éviter dans une grande mesure les limitations apportées par les procédés de l'art antérieur en ce qui concerne la longueur du canal, le transistor D/MOS décrit ci-dessus ne peut évidemment être réalisé que sous la forme d'un transistor discret. Sa fabrication dans un circuit intégré exigerait bien évidemment des étapes supplémentaires destinées à isoler les régions de source et de drain, des autres composants du circuit. Cependant, le brevet des E.U.A. N° 3 996 655 décrit un procédé permettant de fabriquer des transistors MOS dans des circuits intégrés de telle sorte que la réalisation de l'isolement n'exigerait pas davantage d'étapes que dans le cas du procédé décrit plus haut, qui permet d'obtenir des transistors D/MOS discrets comportant un canal dont la longueur est de l'ordre du micron. En bref, ce résultat est obtenu en formant un oxyde sur la surface d'un substrat en matériau de type p-, n- ou $\pi$, puis en pratiquant deux ouvertures dans cet oxyde et en effectuant dans celles-ci une diffusion de type p- de manière à former deux régions de drain. On pratique ensuite une autre ouverture dans laquelle on effectue une diffusion de type n + en même temps que dans les deux ouvertures précédentes de manière à obtenir trois régions de type n +, deux de celles-ci étant formées dans les régions de type p- précédemment obtenues. On obtient ainsi un transistor de commande associé à une charge et cet ensemble est isolé des autres composants dans le substrat par la région importante de type p- qui entoure les deux régions de drain.

D'autres exemples des techniques employées pour réaliser des transistors D/MOS à canal court sont décrits ci-après.

Le brevet des E.U.A. N° 3 685 140 décrit un transistor à effet de champ comportant un canal excessivement court dont un seul bord définit les limites des régions de source et de drain. Dans une réalisation de ce brevet, une électrode de porte est formée au-dessus d'une mince couche d'oxyde déposée sur une tranche semi-conductrice d'un premier type de conductivité. Une impureté du type de conductivité opposé est ensuite diffusée dans la tranche à proximité immédiate de l'électrode de porte. Une impureté d'un premier type de conductivité est diffusée dans la région du type de conductivité opposé pour former un transistor à effet de champ dans lequel l'un des bords des électrodes de porte définit la limite entre la source et le canal et entre le drain et le canal. Dans une autre réalisation, l'un des bords d'une couche d'isolement définit les limites des régions de source et de drain.

Le brevet des E.U.A. N° 4 038 107 décrit un procédé permettant de réaliser un transistor à effet de champ à canal extrêmement court. A cette fin, on procède à une première implantation ionique au travers de l'ouverture que comporte un masque en polysilicium, on convertit la surface de ce dernier en $SiO_2$ de manière à réduire les dimensions de ladite ouverture, puis on effectue une seconde implantation ionique au moyen d'une impureté du type opposé au travers de l'ouverture ainsi réduite. La conversion du polysilicium en $SiO_2$ a pour effet de déplacer le bord du masque d'une faible distance prédéterminée, ce qui permet d'obtenir entre les deux implantations ioniques un faible espacement bien déterminé qui sert à définir un canal extrêmement court. On peut également réaliser un transistor bipolaire comportant une région de base étroite au moyen d'un processus analogue.

Le brevet des E.U.A. N° 4 001 048 décrit une structure MOS qui comporte un corps semi-conducteur d'un type de conductivité donné. Une couche d'un matériau semi-conducteur du type de conductivité opposé est disposée sur ce corps semi-conducteur et présente une surface plane. Un masque présentant une configuration prédéterminée est formé sur cette surface. Une première région du premier type de conductivité est formée par diffusion dans le corps semi-conducteur et est définie par une première jonction PN qui s'étend jusqu'à la surface qui se trouve au-dessous du masque et jusqu'au corps semi-conducteur. Une seconde région diffusée du type de conductivité opposé est formée dans la première région diffusée et est définie par une seconde jonction PN qui s'étend jusqu'à la surface. Ces deux jonctions PN définissent un canal de longueur précise au-dessous du masque. Une couche d'un matériau isolant recouvre la surface. Une métallisation de contact est prévue sur la couche de matériau isolant et traverse cette dernière.

Dans un article intitulé : DIMOS — a novel technology with submicron effective channel MOSFET's, publié dans les Technical Digest 1977 IEDM 5-7 décembre 1977 Washington DC (USA), J. Tihanyi et al décrivent un procédé de fabrication de transistors MOSFET, à canal court de type D · MOS par une double implantation ionique. L'utilisation d'une couche d'oxyde de porte en forme de rampe (ou en forme de marche) permet l'obtention d'une largeur efficace de canal de l'ordre de 1 à 1,5 μm, et donc des performances excellentes. Ce procédé présente néanmoins certaines caractéristiques qui ne sont pas souhaitables.

La formation de la région additionnelle de type p nécessite une étape photolithographique supplémentaire avec les inconvénients connus qui en résultent : défauts d'alignement qui causent des disparités dans les tensions de seuil $V_T$.

Par ailleurs pour obtenir l'effet de masquage, il est nécessaire que la couche d'oxyde de recouvrement soit relativement épaisse, ce qui présente également des inconvénients évidents (difficultés lors du décapage, défaut de planéité de la structure, etc.).

Enfin l'état de la technique comprend également le brevet français N° 1 577 669 qui décrit le procédé de fabrication d'un IGFET dans lequel l'étape de formation des régions complémentaires de source et de drain, par implantation ionique, s'effectue à travers une couche isolante dans les parties de la surface qui ne sont pas masquées par les couches métalliques formant les contacts de source, drain et porte.

### Exposé de l'invention

La présente invention concerne un procédé de fabrication d'IGFET à canal efficace très court, qui ne fait pas appel à l'emploi de la technique dite de double diffusion. Dans les techniques classiques de double diffusion, dont des exemples ont été donnés ci-dessus, le canal se compose de deux régions à tension de seuil faible et à tension de seuil importante. C'est principalement cette dernière région qui détermine les caractéristiques du dispositif et l'on fait en sorte que cette région soit très courte.

Le procédé de la présente invention ressemble aux procédés de l'art antérieur : les dispositifs qu'il permet d'obtenir sont analogues aux transistors D/MOS en ce sens que le canal de ces dispositifs se compose également de deux régions à tension de seuil faible et à tension de seuil importante et que la longueur de cette dernière région est très faible. Cependant, la présente invention diffère des procédés antérieurs car elle permet de faire varier de façon indépendante, par implantation ionique et par décapage chimique, les tensions présentées par ces deux régions ainsi que les longueurs de celles-ci.

La présente invention se caractérise par les étapes suivantes :

A. formation d'une région active dans un substrat semi-conducteur peu dopé (10), d'un premier type de conductivité, muni en surface d'une région superficielle peu dopée (16), d'un second type de conductivité opposé audit premier type et isolée par des régions d'oxyde encastré (12),

B. formation successive sur cette région active d'une couche de masquage composite destinée à définir la région de canal, composée d'une couche isolante de porte, en $SiO_2$ (18), d'une couche de porte en polysilicium (20), d'une couche isolante de recouvrement en $SiO_2$ (22), d'une couche de métal (24) et d'une couche de résine photo-sensible de masquage (26),

C. délimitation de la couche de masquage composite selon une configuration désirée pour définir la région du canal dans ladite région active, et délimiter les régions source et drain,

D. implantation globale d'ions du second type de conductivité pour créer les régions source et drain (28, 30), fortement dopées, auto-alignées avec ladite couche de masquage,

E. élimination latérale partielle de la couche de métal (24) au moins sur le bord du côté de la région source par un décapage chimique humide, et élimination de ladite couche de résine photo-sensible (26),

F. formation d'une seconde couche de masquage (32) qui laisse exposées les portions non recouvertes restantes de la couche de masquage composite faisant face à la région source, et cette dernière

G. implantation globale d'ions du premier type de conductivité pour former une région (34) dont une portion constitue une partie de la région de canal avec une portion de la couche superficielle (16),

H. élimination de la seconde couche de masquage, élimination de la couche de métal et oxydation de la structure et

I. formation des trous de contact avec les différentes régions de source, de drain et de porte et formation du réseau d'interconnexion conducteur selon une configuration désirée.

Dans un second mode de réalisation, les étapes C. à I. sont remplacées par les étapes suivantes :

J. délimitation de la couche de masquage composite selon une configuration désirée pour définir la région source,

K. implantation globale d'ions du second type de conductivité pour créer la région source (28) fortement dopée et auto-alignée avec la couche de masquage composite,

L. élimination latérale partielle de la couche de métal et élimination de ladite couche de résine photo-sensible (26),

M. implantation globale du premier type de conductivité pour former une région (34) dont une portion constitue une partie de la région de canal avec une portion de la couche superficielle (16),

N. formation d'une seconde couche de masquage qui laisse exposée la région de drain,

O. implantation globale d'ions du second type d'impuretés pour former la région de drain (30),

P. élimination de la couche de métal restante, de la seconde couche de masquage et oxydation de la structure, et

Q. formation des trous de contact avec les différentes régions de source, de drain et de porte et formation du réseau d'interconnexion conducteur selon une configuration désirée.

Les dispositifs obtenus sont remarquables tant par leurs dimensions réduites que par leur vitesse de fonctionnement élevée.

D'autres objets, caractéristiques et avantages de la présente invention ressortiront mieux de l'exposé qui suit, fait en référence aux figures annexées à ce texte, qui représentent un mode de réalisation préféré de celle-ci.

Brève description des figures

Les figures 1 à 6 sont des coupes représentant différentes étapes d'une première réalisation conforme au procédé de fabrication d'un IGFET de la présente invention, dans lequel l'auto-alignement de la source et du drain par rapport à la porte est effectué en une seule étape de masquage.

Les figures 7 à 13 sont des coupes illustrant les différentes étapes d'une autre réalisation conforme au procédé de fabrication d'un IGFET de la présente invention, dans lequel différentes étapes de masquage sont employées pour obtenir un auto-alignement de la source et du drain par rapport à la porte.

Description de l'invention

Les transistors à effet de champ à porte isolée (IGFET) comprennent généralement un substrat en un matériau semi-conducteur d'un premier type de conductivité dans lequel des régions discrètes, appelées source et drain du type de conductivité opposé, sont séparées par un canal de faibles dimensions ; sur ce dernier est disposée une électrode de porte qui chevauche lesdites régions. La conduction entre ces dernières s'effectue par l'intermédiaire des parties du canal qui se trouvent à proximité immédiate de la surface. Ce canal est formé et modulé par le potentiel appliqué à l'électrode de porte. La longueur du canal situé entre les deux régions définit un paramètre qui joue un rôle extrêmement important dans le fonctionnement d'un transistor à effet de champ. Pour une largeur donnée du canal, la transconductance est inversement proportionnelle à la longueur du canal. Il est donc possible de réduire les dimensions d'un dispositif présentant une transconductance donnée si l'on peut également réduire la longueur de son canal. Cela provoquerait une diminution non seulement de la capacité de porte, mais aussi de la capacité des conducteurs entre dispositifs associés dans un même circuit intégré. D'autre part, les dispositifs plus petits ainsi obtenus pourraient être disposés de façon plus compacte, ce qui permet en général d'obtenir une plus grande intégration et un meilleur rendement. Par ailleurs, étant donné que la fréquence de fonctionnement d'un transistor à effet de champ est limitée par le temps de transit des porteurs dans le canal, lequel est proportionnel à la longueur de ce dernier, toute réduction de cette longueur permet également d'augmenter ladite fréquence.

Les différentes étapes des deux versions ou réalisations du procédé de la présente invention permettant de fabriquer un IGFET dont on peut faire varier de façon indépendante les tensions de seuil présentées par les deux régions constituant le canal ainsi que les longueurs de ces régions, et en outre dont la source et le drain sont auto-alignés par rapport à la porte, sont décrites ci-après.

Dans la première version du présent procédé, les deux côtés de la région du canal sont ouverts avant l'implantation.

Les deux versions présentent des étapes de départ qui sont communes. On prépare tout d'abord un substrat composé d'un matériau semi-conducteur approprié tel que du silicium de type p-.

Les étapes préparatoires sont bien connues et ne sont donc pas représentées sur les figures. En fait une première couche d'un matériau isolant tel que du dioxyde de silicium (SiO$_2$) est formée sur la surface supérieure du substrat semi-conducteur au moyen de techniques classiques d'oxydation thermique ; l'épaisseur de la couche ainsi obtenue devant être comprise entre 50 et 500 Angströms. Une couche de nitrure de silicium (Si$_3$N$_4$) d'une épaisseur comprise entre 200 et 2 000 Angströms est ensuite formée sur le dioxyde de silicium par dépôt en phase vapeur ou par toute autre technique. Une autre couche de SiO$_2$ est ensuite déposée sur le nitrure de silicium par dépôt en phase vapeur ou par toute autre technique de manière à obtenir une troisième couche d'une épaisseur comprise entre 200 et 2 000 Angströms.

Un premier masque est ensuite employé en conjonction avec des techniques photolithographiques et de décapage classiques pour décaper ces trois couches à l'exception d'une partie rectangulaire de celles-ci qui recouvre ce qui constituera la région du canal dans le dispositif finalement obtenu.

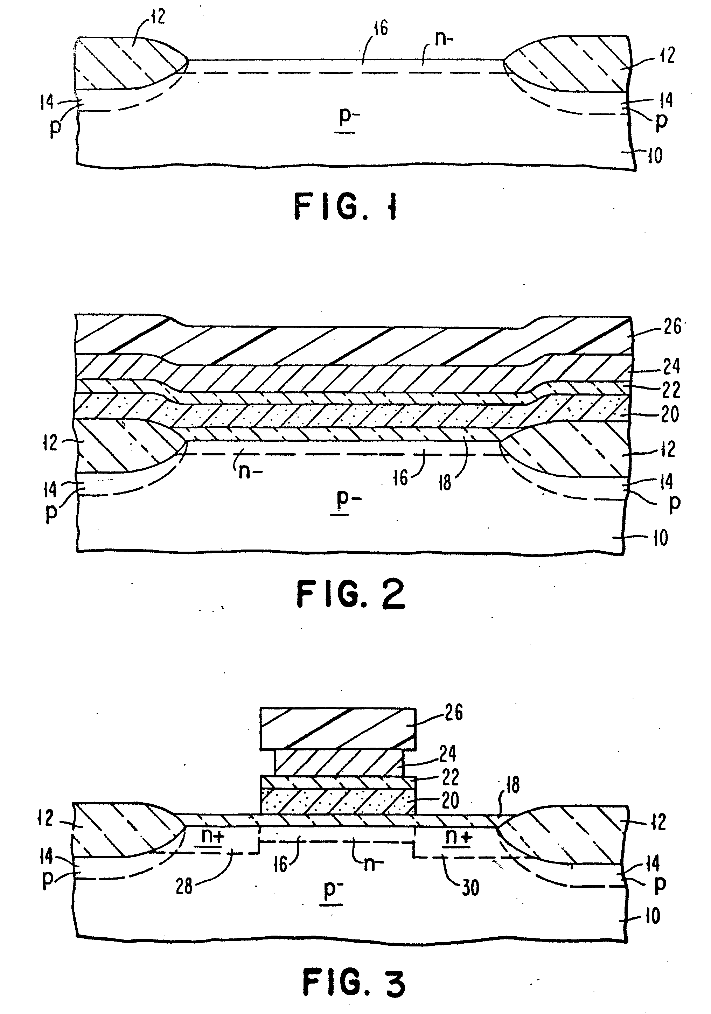

La région de protection de champ est ensuite formée par implantation ionique, en utilisant du bore comme dopant, et l'on fait croître de l'oxyde thermique dans le substrat en silicium de manière à former une région d'oxyde encastré d'une épaisseur comprise entre 3 000 et 10 000 Angströms qui assure l'isolement. On retire ensuite les trois couches (SiO$_2$, Si$_3$N$_4$ et SiO$_2$) recouvrant la future région du canal et l'on forme cette dernière par implantation ionique en utilisant du phosphore ou de l'arsenic aux fins d'un réglage du seuil en mode d'appauvrissement. La structure résultante est représentée sur la figure 1 et comprend le substrat 10, la couche d'oxyde encastré 12, la région implantée de protection de champ 14 qui s'est étalée pendant la formation de la couche 12, et la couche implantée superficielle 16 de type n-. La portion du substrat comprise dans les limites de la région d'oxyde encastré constitue la région active du dispositif à fabriquer.

Pendant l'étape suivante, représentée sur la figure 2, on fait croître thermiquement une couche d'oxyde de porte 18 (SiO$_2$) d'une épaisseur comprise entre 100 et 2 000 Angströms. Une couche mince de polysilicium est ensuite formée par dépôt en phase vapeur de manière à obtenir une porte en polysilicium d'une épaisseur comprise entre 2 000 et 7 000 Angströms. Cette couche 20 est ensuite dopée au moyen d'une impureté de type n + et une couche 22 en SiO$_2$ d'une épaisseur comprise entre 500 et 2 000 Angströms est formée thermiquement ou par dépôt en phase vapeur. La couche de polysilicium peut également être dopée « in situ » pendant le dépôt. On recouvre ensuite la couche 22 d'une couche 24 de tungstène qui servira de masque pendant l'implantation. A cette fin, on recouvre la couche 24 d'une couche de résine photosensible 6. L'ensemble constitue une couche de masquage composite.

Une fois que la structure représentée sur la figure 2 a été réalisée, on peut procéder de deux façons distinctes, qui restent des variantes d'exécution, et relèvent du même concept inventif.

Premier mode de réalisation : dans une première version du procédé de l'invention, un masque est disposé au-dessus de la couche de résine photosensible 26, cette dernière est exposée, développée et décapée chimiquement.

Puis successivement le tungstène (par exemple par décapage chimique), le SiO$_2$ et le polysilicium exposés sont retirés par des techniques de décapage sélectif (par exemple par décapage par ions réactifs), de manière à former l'ensemble représenté sur la figure 3. Sur cette dernière figure les régions de source et de drain ainsi que la porte en polysilicium 20 sont clairement définies. Les régions de source et de drain sont formées par implantation ionique en utilisant du phosphore ou de l'arsenic comme dopant. La couche d'oxyde encastré 12 et la couche de résine 26 servant de masques aux fins de l'implantation. Les régions de source et de drain 28 et 30 sont auto-alignées avec la porte 20.

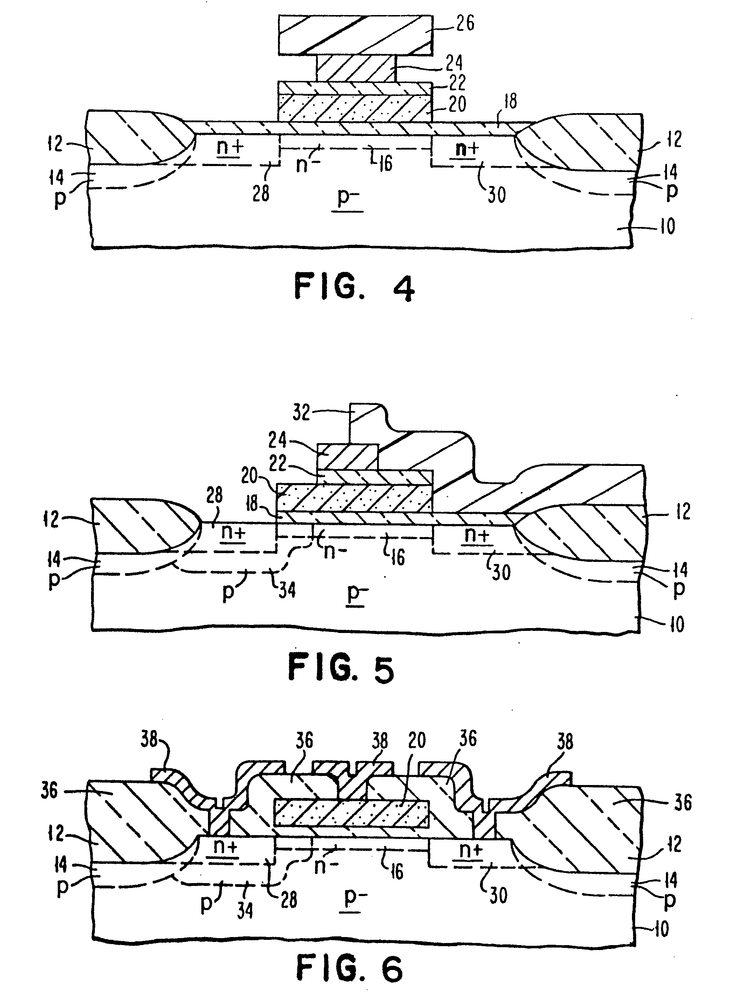

Ensuite, sans retirer la couche de résine 26, on procède à un décapage chimique humide pour décaper latéralement la couche de tungstène 24, de la façon indiquée sur la figure 4, de manière à obtenir une place supplémentaire qui sera nécessaire pour une implantation ionique ultérieure sur le bord de la source aux fins d'un ajustement de la tension de seuil. On élimine la couche de résine 26. Comme le montre la figure 5, une seconde couche de masquage constituée par une nouvelle couche 32 de résine photosensible est alors appliquée sur la structure obtenue et est ensuite masquée, exposée, développée selon une configuration désirée afin d'être décapée au-dessus du côté « source ». On élimine les portions exposées des couches de SiO$_2$ 18 et 22. Une implantation d'ions bore est alors réalisée en utilisant la couche de tungstène 24 et la couche de résiné photosensible 32 comme masques. Comme le montre la figure 5, le bore pénètre profondément dans la région de source 28 et peu profondément dans la région du canal située au-dessous de la couche de polysilicium 20 parce que cette dernière fait fonction de masque pour la région du canal. Ainsi, la région implantée obtenue 34 peut être ajustée pour obtenir la tension de seuil $V_T$ désirée équivalente aux régions de tensions de seuil élevée et de seuil faible que présentent les transistors de type D/MOS. En effet, le canal est formé de deux régions, à savoir la région implantée 34 dans sa portion située au-dessous de la couche de SiO$_2$ 18 et la région implantée 16 au-dessous de cette même couche 18.

Ensuite, on retire la couche de résine 32 et la portion restante de tungstène 24, et l'on fait de nouveau croître du dioxyde de silicium pour former une couche 36 de $SiO_2$, comme le montre la figure 6. On peut utiliser d'abord une oxydation thermique pour former cette couche 36, puis procéder à un dépôt chimique en phase vapeur pour activer le processus de formation. Des trous de contact sont ensuite réalisés dans la couche 36 au niveau des régions de source, de drain et de porte, comme le montre la figure 6, en utilisant des procédés classiques de masquage photolithographique et de décapage. On procède enfin à une métallisation de la structure résultante au moyen d'une couche 38 d'aluminium ou de ($Pd_2Si$ + Al) ; la délimitation de la couche de métal 38 étant effectuée au moyen de techniques connues. Cette couche de métal ainsi délimitée constitue le réseau conducteur d'interconnexion.

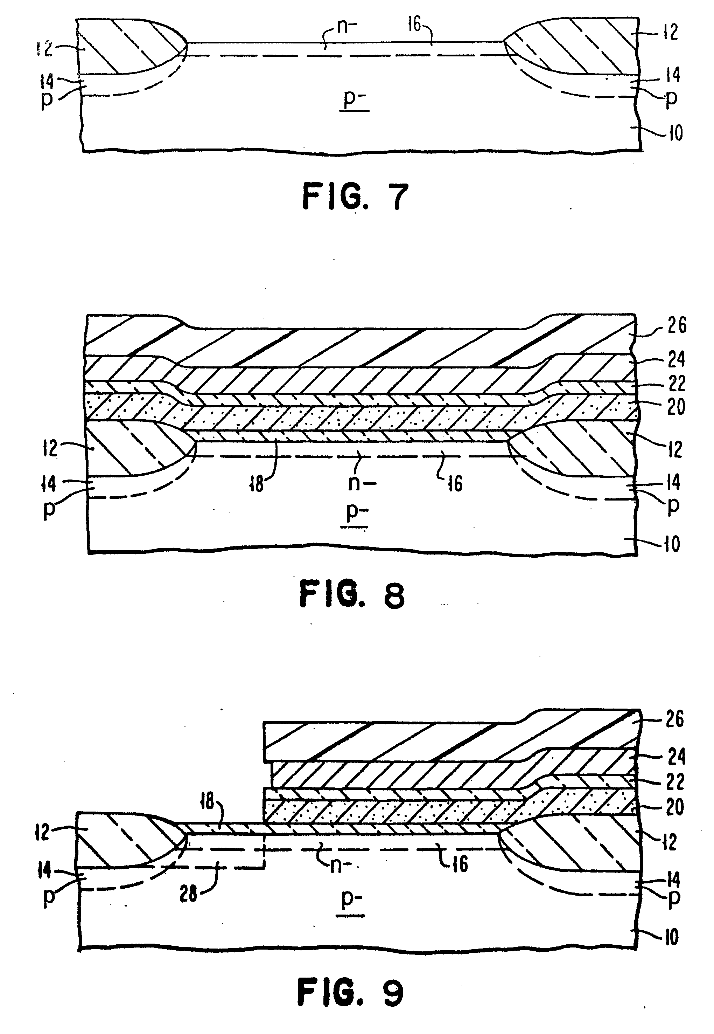

Deuxième mode de réalisation : l'autre version du présent procédé est décrite ci-après et peut être employée si, pour une raison quelconque, la seconde couche de masquage en résine photosensible 32 de la figure 5 n'assure pas un masquage adéquat aux fins de la formation de la région implantée 34 qui est utilisée pour l'ajustement de la tension de seuil. En pareil cas, on peut utiliser la version ci-après dans laquelle un seul côté ou bord (le côté « source ») de la structure est exposé. Les premières étapes de cette version sont les mêmes que celles précédemment décrites et les figures 7 et 8 de cette version sont identiques aux figures 1 et 2 de la précédente.

Après avoir obtenu la structure représentée sur la figure 8, la couche de résine photosensible 26 est masquée selon une configuration désirée, exposée, et développée. La couche de tungstène exposée 24 est alors décapée chimiquement, puis les parties exposées de la couche de $SiO_2$ 22 et de la couche de polysilicium 20 sont retirées par décapage réactif de manière à constituer la structure représentée sur la figure 9, dans laquelle seule la région de source est exposée. La différence fondamentale entre les structures des figures 3 et 9 réside dans la configuration du masque utilisé aux fins de leur réalisation. La région de source 28 est ensuite formée par implantation ionique et est auto-alignée par rapport à la porte en polysilicium 20 en raison de l'effet de masquage obtenu grâce à la couche d'oxyde encastrée 12 d'un côté de la combinaison des couches de polysilicium 20, de $SiO_2$ 22, de tungstène 24 et de résine photosensible 26, de l'autre côté. Il serait également possible d'implanter la région de source 28 en même temps que la région de drain.

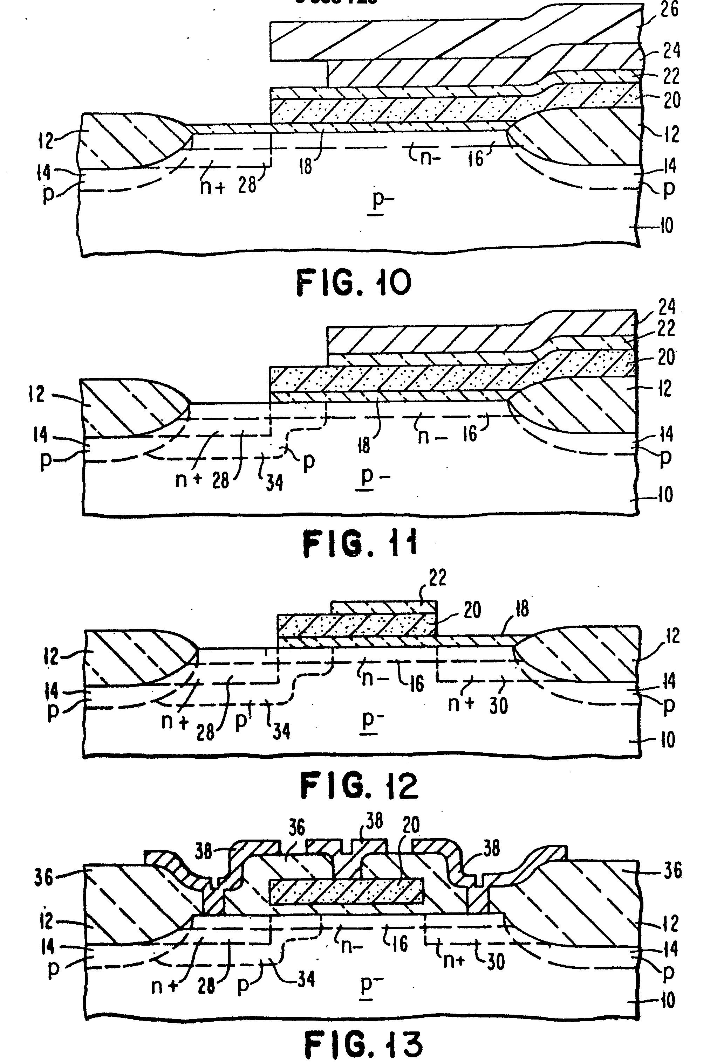

La partie de la couche de tungstène 24 qui se trouve du même côté que la source fait l'objet d'un décapage latéral réalisé au moyen d'un décapage chimique humide de la façon précédemment décrite à propos de la figure 4 de manière à obtenir la structure représentée sur la figure 10. La couche de résine photosensible 26 est ensuite retirée et les parties exposées des couches de $SiO_2$ 18 et 22 sont décapées, ce qui permet d'obtenir la structure représentée sur la figure 11.

On procède ensuite à l'implantation ionique de bore ou de tout autre dopant approprié. La couche de $SiO_2$ 22 et la couche de tungstène 24 s'opposent à toute implantation du côté « drain » de la structure. La partie de la couche de polysilicium 20 qui se trouve au-dessus de l'extrémité gauche du canal limite l'implantation effectuée dans cette région par rapport à celle effectuée dans la région de source exposée 28. La région implantée 34 représentée sur la figure 11 permet d'obtenir l'ajustement de la tension de seuil qui rend, comme on l'a vu la performance de la structure analogue à celle d'un transistor du type D/MOS.

Au cours de l'étape suivante, la couche de tungstène 24 est retirée et une couche de résine photosensible est formée au-dessus de la structure. Des techniques lithographiques classiques comprenant une seconde couche de masquage sont employées pour définir la porte du côté « drain » de la structure et pour exposer la région de drain. La couche de résine est ensuite retirée et on procède à une nouvelle implantation ionique pour former la région de drain 30, comme le montre la figure 12. On notera que l'étape d'implantation permettrait également d'implanter la région de source 28. L'étape précédente d'implantation de la région de source 28 représentée sur la figure 9 peut donc être éventuellement supprimée et la région 28 peut être formée en même temps que la région de drain 30 au cours de l'étape représentée sur la figure 12.

Enfin, de même que dans l'étape représentée sur la figure 6, une couche de $SiO_2$ 36 est en partie formée par oxydation thermique, et en partie par dépôt chimique en phase vapeur. Des trous de contact sont ensuite réalisés dans les régions de source, de porte et de drain, et une couche de métal 38 est déposée, puis délimitée.

Dans le présent procédé, qui comporte les deux versions décrites ci-dessus, la longueur de la région du canal qui présente une tension de seuil élevée est définie au moyen de l'étape de décapage du tungstène. Le tungstène est employé en raison de ses caractéristiques de décapage bien connues, mais d'autres métaux tels que l'or, le molybdène, le chrome, le titane-chrome, etc. peuvent également être utilisés. Au lieu de la résine photosensible, on peut utiliser du $SiO_2$ pulvérisé comme masque de décapage pour la couche métallique.

Dans la première version du procédé représentée sur les figures 1 à 6, l'auto-alignement de la source et du drain par rapport à la porte est effectué en une seule étape de masquage, et de ce fait la longueur de la région du canal qui présente une tension de seuil élevée peut être commandée avec précision. Dans la seconde version, illustrée sur les figures 7 à 13, des étapes de masquage distinctes permettent d'obtenir cet auto-alignement et, de ce fait, il est moins facile de commander la longueur de la région présentant une faible tension de seuil. Néanmoins les variations de la longueur de cette dernière région ont un effet minime sur les caractéristiques du dispositif, lesquelles sont essentiellement déterminées par l'autre région du canal.

Application industrielle

Le procédé de la présente invention permet de fabriquer des transistors, notamment des transistors à effet de champ à porte isolée (IGFET) à canal très court de manière à améliorer leur réponse en fréquence ou leur vitesse de fonctionnement. Le présent procédé permet également d'obtenir un IGFET dont le canal se compose de deux régions présentant respectivement une tension de seuil élevée et une faible tension de seuil, et qui possède donc les propriétés d'un transistor D/MOS. Toutefois, contrairement aux procédés actuels de fabrication de transistors D/MOS, le présent procédé permet de faire varier de façon indépendante la longueur du canal et les tensions de seuil.

Le présent procédé n'exige pas l'emploi d'outils lithographiques perfectionnés, ni l'exécution d'étapes d'alignement critiques ; il permet de fabriquer à la fois sur un même bloc des dispositifs fonctionnant en mode d'enrichissement et des dispositifs fonctionnant en mode d'appauvrissement. Les cycles thermiques que prévoit le procédé sont beaucoup moins poussés que ceux des procédés classiques de fabrication de transistors D/MOS, ce qui permet de mieux commander les profils de dopage dans les régions du canal et de champ.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

## Revendications

1. Procédé de fabrication de transistors à effet de champ et à porte isolée à canal efficace très court, ce dernier du genre comprenant des régions à tension de seuil élevée et à tension de seuil faible, caractérisé en ce qu'il comporte les étapes suivantes :

A. formation d'une région active dans un substrat semi-conducteur peu dopé (10), d'un premier type de conductivité, muni en surface d'une région superficielle peu dopée (16), d'un second type de conductivité opposé audit premier type et isolée par des régions d'oxyde encastré (12),

B. formation successive sur cette région active d'une couche de masquage composite destinée à définir la région de canal, composée d'une couche isolante de porte, en SiO$_2$ (18), d'une couche de porte en polysilicium (20), d'une couche isolante de recouvrement en SiO$_2$ (22),

d'une couche de métal (24) et d'une couche de résine photo-sensible de masquage (26),

C. délimitation de la couche de masquage composite selon une configuration désirée pour définir la région de canal dans ladite région active, et délimiter les régions source et drain,

D. implantation globale d'ions du second type de conductivité pour créer les régions source et drain (28, 30), fortement dopées, auto-alignées avec ladite couche de masquage,

E. élimination latérale partielle de la couche de métal (24) au moins sur le bord du côté de la région source par un décapage chimique-humide, et élimination de ladite couche de résine photo-sensible (26),

F. formation d'une seconde couche de masquage (32) qui laisse exposées les portions non recouvertes restantes de la couche de masquage composite faisant face à la région source, et cette dernière

G. implantation globale d'ions du premier type de conductivité pour former une région (34) dont une portion constitue une partie de la région de canal avec une portion de la couche superficielle (16),

H. élimination de la seconde couche de masquage, élimination de la couche de métal et oxydation de la structure et

I. formation des trous de contact avec les différentes régions de source, de drain et de porte et formation du réseau d'interconnexion conducteur selon une configuration désirée.

2. Procédé de fabrication selon la revendication 1 caractérisé en ce que les étapes C. à I. sont remplacées par les étapes suivantes :

J. délimitation de la couche de masquage composite selon une configuration désirée pour définir la région source,

K. implantation globale d'ions du second type de conductivité pour créer la région source (28) fortement dopée et auto-alignée avec la couche de masquage composite,

L. élimination latérale partielle de la couche de métal et élimination de ladite couche de résine photo-sensible (26),

M. implantation globale du premier type de conductivité pour former une région (34) dont une portion constitue une partie de la région de canal avec une portion de la couche superficielle (16),

N. formation d'une seconde couche de masquage qui laisse exposée la région de drain,

O. implantation globale d'ions du second type d'impuretés pour former la région de drain (30),

P. élimination de la couche de métal restante, de la seconde couche de masquage et oxydation de la structure, et

Q. formation des trous de contact avec les différentes régions de source, de drain et de porte et formation du réseau d'interconnexion conducteur selon une configuration désirée.

3. Procédé de fabrication selon la revendication 2 caractérisé en ce que l'étape K. est supprimée et que la région source est formée simultanément avec la région drain lors de l'étape O.

4. Procédé de fabrication selon l'une des revendications 1 à 3 caractérisé en ce que préalablement à la formation des régions d'oxyde encastré, on a formé à cet emplacement des régions de protection de champ.

5. Procédé de fabrication selon l'une des revendications 1 à 4 caractérisé en ce que ladite couche de porte en polysilicium est dopée pour en accroître la conductivité.

6. Procédé de fabrication selon l'une des revendications 1 à 5 caractérisé en ce que ledit métal est du tungstène et que les impuretés implantées lors des étapes G. et M. sont des ions bore.

7. Procédé de fabrication selon l'une des revendications 1 à 6 caractérisé en ce que, après les étapes E. et L. on procède également à l'élimination de la portion exposée de la couche isolante de recouvrement (22) afin que la couche de polysilicium (20) soit exposée à son tour en vue de l'étape d'implantation ionique qui suit.

## Claims

1. Fabrication procedure for field-effect transistors (FETs) with insulated gates and very short active channels, the latter of the type including regions with a high threshold voltage and a low threshold voltage, characterized in that it includes the following steps :

A. formation of an active region in a lightly doped semiconductor substrate (10), of a first type of conductivity, having at the surface a superficial lightly doped region (16), of a second type of conductivity opposed to the said first type, and insulated by recessed oxide regions (12),

B. successive formation on this active region of a composite masking layer, designed to define the channel zone, composed of a gate-insulating layer of SiO$_2$ (18), of a polysilicon gate layer (10), of a covering insulating layer of SiO$_2$ (22), of a metal layer (24), and of a layer of photosensitive masking resin (26),

C. delimiting the composite masking layer according to a desired configuration, to define the channel zone in the said active region, and to determine the source and drain zones,

D. blanket implantation of the ions of the second type of conductivity, to create the source and drain zones (28, 30), heavily doped, self-aligned with the said masking layer,

E. partial lateral elimination of the metal layer (24), at least on the edge near the source zone, by wet chemical cleaning, and elimination of the said layer of photosensitive resin (26),

F. formation of a second masking layer (32), which leaves exposed the remaining non-covered portions of the composite masking layer facing the source zone, and the latter,

G. blanket implantation of the ions of the first type of conductivity to form a zone (34), a portion of which constitutes part of the channel zone with a portion of the superficial layer (16),

H. elimination of the second masking layer, elimination of the metal layer and oxidation of the structure, and

I. formation of contact holes with the different source, drain, and gate zone, and formation of the interconnection conductor network in accordance with a desired configuration.

2. Fabrication procedure in accordance with claim 1, characterized in that steps C to I are replaced by the following steps :

J. delimiting the composite masking layer in accordance with a desired configuration to define the source zone,

K. blanket implantation of ions of the second type of conductivity, to create the source zone (28), heavily doped and self-aligned with the composite masking layer,

L. partial lateral elimination of the layer of metal and elimination of the said layer of photosensitive resin (26),

M. blanket implantation of the first type of conductivity to form a zone (34), a portion of which constitutes part of the channel zone, with a portion of the superfical layer (16),

N. formation of a second masking layer, which leaves the drain zone exposed,

O. blanket implantation of ions of the second type of impurities, to form the drain zone (30),

P. elimination of the remaining metallic layer, of the second masking zone and oxidation of the structure, and

Q. formation of contact holes with the different source, drain, and gate zones, and formation of the conductor interconnection network in accordance with a desired configuration.

3. Fabrication procedure in accordance with claim 2, characterized in that step K is eliminated and the source zone is formed simultaneously with the drain zone during step O.

4. Fabrication procedure in accordance with any one of the claims 1 to 3, characterized in that prior to the formation of the embedded oxide regions, field-protection regions were formed at this location.

5. Fabrication procedure in accordance with any one of the claims 1 to 4, characterized in that the said polysilicon gate layer is doped to increase its conductivity.

6. Fabrication procedure in accordance with any one of the claims 1 to 5, characterized in that the said metal is tungsten and that the impurities implanted during steps G to M are boron ions.

7. Fabrication procedure in accordance with any one of the claims 1 to 6, characterized in that, after steps E and L, also eliminated is the exposed portion of the covering insulating layer (22), so that the polysilicon layer (20) is exposed in turn in view of the following ion-implanting step.

## Ansprüche

1. Verfahren für die Herstellung von Isolierschicht-Feldeffekttransistoren mit sehr kurzem wirksamem Kanal, der Zonen mit hoher Schwellenspannung und Zonen mit niedriger Schwellenspannung enthält, dadurch gekennzeichnet, daß es folgende Stufen enthält :

A. Bildung einer aktiven Zone in einem gering dotierten Halbleitersubstrat (10) von einem ersten Leitfähigkeitstyp, an der Oberfläche mit einer niedrig dotierten Zone (16) von einem dem ersten Typ entgegengesetzten zweiten Leitfähigkeitstyp versehen und durch zwischengeschaltete Oxydzonen (12) isoliert,

B. stufenweise Bildung einer zusammengesetzten ersten, die Kanalzone definierenden Schicht auf dieser aktiven Zone, die aus einer Gateisolationsschicht aus $SiO_2$ (18), einer Gateschicht aus Polysilizium (20), einer Isolierschicht aus $SiO_2$ (22), einer Metallschicht (24) und aus einer Photolackschicht (26) besteht,

C. Abgrenzung der zusammengesetzten ersten Schicht, um die Kanalzone in der genannten aktiven Zone zu definieren und die Zonen von Quelle und Senke zu begrenzen,

D. Implantation von Ionen vom zweiten Leitfähigkeitstyp zur Erzeugung von Quelle und Senke (28, 30), stark dotiert und automatisch zur genannten ersten Schicht ausgerichtet,

E. teilweise seitliche Entfernung der Metallschicht (24) wenigstens am Rand der Quellenzone durch Ätzen und Entfernung der genannten Photolackschicht (26),

F. Bildung einer zweiten Schicht (32), die die verbleibenden nicht bedeckten Teile der zusammengesetzten ersten Schicht gegenüber der Quellenzone und diese letztere freiläßt,

G. Implantation von Ionen vom ersten Leitfähigkeitstyp zur Bildung einer Zone (34), von der ein Abschnitt einen Teil der Kanalzone mit einem Abschnitt der Zone (16) bildet,

H. Entfernung der zweiten Schicht, Entfernung der Metallschicht und Oxydierung der Struktur und

I. Herstellung von Kontaktlöchern zu den verschiedenen Zonen von Quelle, Senke und Gate und Herstellung des leitenden Anschlußnetzes.

2. Herstellungsverfahren nach Anspruch 1, dadurch gekennzeichnet, daß die Schritte C bis I durch folgende Schritte ersetzt sind :

J. Begrenzung der ersten Schicht zur Definition der Quellenzone,

K. Implantation von Ionen des zweiten Leitfähigkeitstyps zur Erzeugung der Quellenzone (28), stark dotiert und automatisch ausgerichtet entsprechend der ersten Schicht,

L. seitliche Entfernung der Metallschicht und Entfernung der genannten Photolackschicht (26),

M. Implantation von Ionen des ersten Leitfähigkeitstyps zur Bildung einer Zone (34), von der ein Abschnitt einen Teil der Kanalzone mit einem Abschnitt der Zone (16) bildet,

N. Bildung einer zweiten Schicht mit Aussparung der Senkenzone,

O. Implantation von Ionen des zweiten Leitfähigkeitstyps zur Bildung der Senkenzone (30),

P. Entfernung der verbleibenden Metallschicht, der zweiten Schicht und Oxydierung der Struktur, und

Q. Herstellung von Kontaktlöchern zu den verschiedenen Zonen von Quelle, Senke und Gate und Bildung des leitenden Anschlußnetzes.

3. Herstellungsverfahren nach Anspruch 2, dadurch gekennzeichnet, daß die Stufe K weggelassen wird und daß in Stufe O die Quellenzone gleichzeitig mit der Senkenzone hergestellt wird.

4. Herstellungsverfahren nach einem der Ansprüche 1 bis 3, dadurch gekennzeichnet, daß vor der Bildung der isolierenden Oxydzonen (12) an dieser Stelle Feldschutzzonen gebildet wurden.

5. Herstellungsverfahren nach einem der Ansprüche 1 bis 4, dadurch gekennzeichnet, daß die genannte Gateschicht aus Polysilizium dotiert wird, um ihre Leitfähigkeit zu vergrößern.

6. Herstellungsverfahren nach einem der Ansprüche 1 bis 5, dadurch gekennzeichnet, daß als Metall Wolfram verwendet wird und daß die in den Stufen G und M eingesetzten Fremdstoffe Borionen sind.

7. Herstellungsverfahren nach einem der Ansprüche 1 bis 6, dadurch gekennzeichnet, daß nach den Stufen E und L auch der freigelegte Abschnitt der deckenden Isolierschicht (22) entfernt wird, damit die Polysiliziumschicht (20) ihrerseits für die darauffolgende Ionenimplantation freigelegt wird.

FIG. 1

FIG. 2

FIG. 3

FIG. 4

FIG. 5

FIG. 6

FIG. 7

FIG. 8

FIG. 9

0 005 720

FIG. 10

FIG. 11

FIG. 12

FIG. 13